# EUROPEAN PATENT APPLICATION

(11) **EP 4 203 211 A1**
(43) Date of publication of application: **28.06.2023**
(21) Application number: 22206321.6
(22) Date of filing: 09.11.2022
(51) Int. Cl.: H01S 5/30, H01S 5/20, H01S 5/323, H01S 5/12, H01S 5/22

(54) **SEMICONDUCTOR LASER DIODE INCLUDING INVERTED P-N JUNCTION**

(30) Priority: 23.12.2021 US 202117560445
(71) Applicant: II-VI Delaware, Inc., Wilmington, Delaware 19801 (US)
(72) Inventor: Zibik, Evgeny, 8053 Zurich (CH); Maineult, Wilfried, 8050 Zurich (CH)
(74) Representative: Marks & Clerk LLP

(57) **Abstract**

An edge-emitting GaAs-based semiconductor laser uses a tunnel junction in combination with an inverted p-n junction to address oxidation problems associated with the use of a high aluminum content p-type cladding arrangement. In particular, a tunnel junction (14) is formed on an n-type GaAs substrate (12), with p-type cladding (16) and waveguiding (18) layers formed over the tunnel junction. N-type waveguiding (22) and cladding (24) layers are thereafter grown on top of the active region (20). Since the p-type layers (16, 18) are positioned below the active region (14) and not exposed to air during processing, a relative high aluminum content may be used, which improves the thermal and electrical properties of the device. Since the n-type material (22, 24) does not require a high aluminum content, it may be further processed to form a ridge structure (24a) without introducing any substantial oxidation of the structure.

## Description

### Technical Field

The present invention relates to semiconductor laser diodes and, more particularly, to an edge-emitting GaAs-based semiconductor laser diode with an inverted junction arrangement that allows for improved thermal control, particularly well-suited for high-power applications.

### Background of the Invention

An electrically-pumped semiconductor laser is based upon the use of a p-n junction ("diode") that introduces both holes (from the p-type material) and electrons (from the n-type material) into an active region that is formed to generate light from the introduced holes and electrons ("free carriers"). GaAs-based diode lasers are typically grown on n-type substrate material, since the n-type structure is generally of higher quality than its p-type counterpart. In most cases, single crystal n-GaAs is therefore used as the base material for GaAs-based semiconductor lasers.

In the last few years, developers have been able to create relatively high power GaAs-based semiconductor lasers by increasing the length of the optical cavity (e.g., in the range of 4 - 6 mm in length). With this approach, a single mode power greater than 2W can be achieved, with the ability to reach an output power greater than 25W in the multimode regime of a single emitter. In such a long cavity structure, however, free carrier absorption becomes a significant source of optical loss. Electrons are less absorbing than holes, so improved high power structures have been based on the use of an asymmetric waveguide with the optical mode occupying more of the n-type waveguiding layer than the p-type layer.

The relatively high aluminum content (typically in the range of 30-80%) required to create the asymmetric structure creates a new problem in terms of thermal management. In particular, for aluminum percentages in the range mentioned above, the created layers exhibit the highest thermal resistivity of the laser structure. A high aluminum percentage is also associated with a low hole mobility condition. These mechanisms result in generating a large amount of heat that must be extracted to maintain acceptable operation, particularly in the high power regime.

### Summary of the Invention

The needs remaining in the art are addressed by the present invention, which relates to semiconductor laser diodes and, more particularly, to an edge-emitting GaAs-based semiconductor laser diode with an inverted junction arrangement that allows for improved thermal control, particularly well-suited for high-power applications.

In accordance with the principles of the present invention, a high-power GaAs-based semiconductor laser uses a tunnel junction in combination with an inverted p-n junction to overcome the oxidation problems associated with the use of a high aluminum content p-type cladding arrangement. In particular, a tunnel junction is formed on an n-type substrate (the preferred starting material), with high aluminum content p-type cladding and waveguiding layers then formed over the tunnel junction. The active region (which may comprise a MQW, DH, quantum dot, wire, etc.) is then formed over the p-type layers, with n-type waveguiding and cladding layers grown on top of the active region. Thus, the resulting structure is "inverted" with respect to the prior art, since the p-type layers are positioned below the active region and the n-type layers are positioned above the active region. The n-type material does not require a high aluminum content to exhibit the necessary performance parameters and, therefore, may be further processed to form a preferred ridge structure without introducing any substantial oxidation of the structure.

In some preferred embodiments, the tunnel junction is tailored (etched and patterned) to assist in current confinement within the desired portion of the active region. The inverted junction laser may also be formed as a distributed feedback (DFB) laser, with the required Bragg grating formed within the n-type waveguiding layer above the active region.

An exemplary embodiment may take the form of an edge-emitting GaAs-based laser formed on an n-type GaAs substrate (the substrate defined as having a top major surface and an opposing bottom major surface), with the laser structure including: a tunnel junction formed on the top major of the n-GaAs substrate, a p-type cladding layer formed over the tunnel junction, a p-type waveguiding layer formed over the p-type cladding layer, an active region disposed on the formed p-type waveguiding layer, an n-type waveguiding layer formed over the active region, a first n-type ohmic contact coupled to the n-type waveguiding layer, and a second n-type ohmic contact coupled to the bottom major surface of the n-type GaAs substrate.

Other and further aspects and embodiments of the present invention will become apparent during the course of the following discussion and by reference to the accompanying drawings.

### Brief Description of the Drawings

Referring now to the drawings, where like numerals represent like parts in several views:
FIG. 1 is a simplified depiction of a conventional prior art edge-emitting semiconductor laser, oriented to illustrate the axial extent of the active region and the exit of the optical emission along an end facet of the laser structure;
FIG.2 includes plots of material properties of AlGaAs as used in waveguiding layers in a conventional GaAs-based edge-emitting semiconductor laser, where FIG. 2(a) is a plot of thermal resistivity as function of the percentage of Al composition, and FIG. 2(b) is a plot of hole mobility as a function of the percentage of Al composition;
FIG. 3 illustrates an exemplary inverted junction GaAs-based semiconductor laser formed in accordance with the principles of the present invention, oriented as a side view of the laser structure;
FIG. 4 is a cut-away end view of the inventive laser of FIG. 3, taken along line 4-4 of FIG. 3;
FIG. 5 is a cut-away end view of an alternative embodiment of the inverted junction edge-emitting laser of the present invention, in this case using a tunnel junction that is shaped as a strip to improve current confinement within the active region;
FIG. 6 illustrates another embodiment of the inverted junction edge-emitting semiconductor layer of the present invention, in this case formed as a DFB laser and including a grating structure formed within the n-type waveguiding layer located over the active region; and
FIG. 7 is a cut-away end view of the DFB laser structure of FIG. 6, particularly illustrating the relationship between the optical mode and the position of the grating structure with respect to the active region.

### Detailed Description

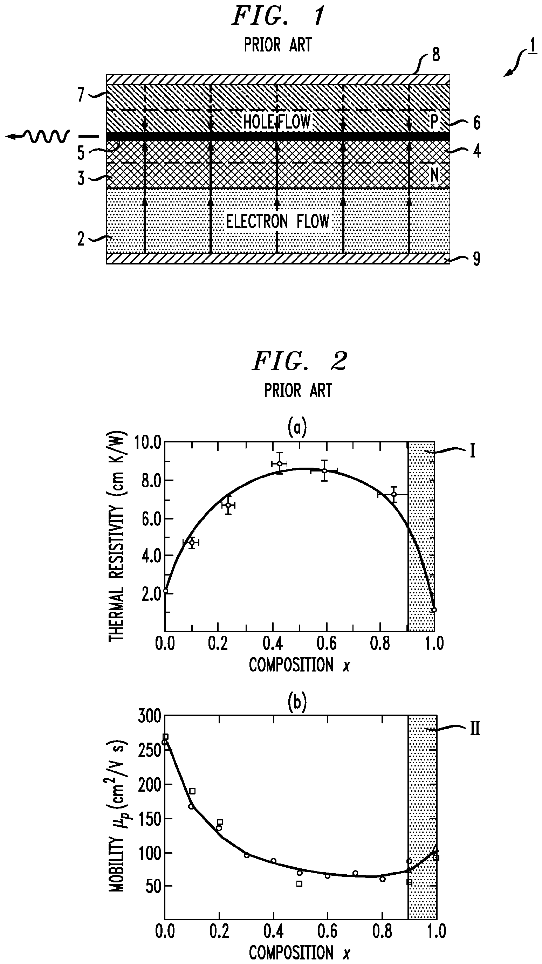

A schematic depiction of a prior art edge-emitting semiconductor diode laser 1, as grown on a single crystal n-type GaAs substrate 2, is shown in FIG. 1. In this case, an n-type cladding layer 3 and an n-type waveguide layer 4 are grown first on n-GaAs substrate 2, followed by an active region 5 that is created in a well-known manner to generate the optical emission from the electrical carriers (holes, electrons) entering the active region. In the orientation of the schematic of FIG. 1, the laser output is shown as exiting along the facet (edge) on the left-hand side of the illustration.

Continuing with the description of this prior art edge-emitting device, a p-type waveguide layer 6 and a p-type cladding layer 7 are grown on top of active region 5. The epitaxial growth is concluded with a p-type contact layer, which is used for formation of a first ohmic p-contact 8. A second ohmic contact 9 is formed of n-type material and is disposed across the bottom of n-GaAs substrate 2. With this arrangement, electrons are supplied to active region 5 from second ohmic 9 via n-type substrate 2, n-cladding layer 3 and n-waveguiding layer 4. Holes are provided into active region 5 from first ohmic contact 8 via p-cladding layer 7 and p-waveguide layer 6.

In a typical GaAs-based laser diode, the p-type cladding layer is formed of AlGaAs, where a relatively high aluminum content would be desirable for device performance. However, the presence of a large aluminum content results in the cladding layer oxidizing when exposed to humid air during the fabrication, forming an AlOx layer. The thickness of such an AlOx layer is difficult to control, as it depends on temperature, humidity and exposure time. Uncontrolled formation of such an AlOx layer is especially undesirable for high power single mode lasers, where the additional stress associated with its variability can be detrimental both for performance (reducing linear power) and reliability.

In order to reduce the possibility of unwanted oxidation, an AlGaAs layer with a relatively low Al content (e.g., about 40%) is generally used in the formation of the p-type cladding. However, as can be seen in FIG. 2, AlGaAs layers with an Al composition of ~40% are least desirable from an operational point of view, as exhibiting a highest thermal resistivity (FIG. 2(a)) across the aluminum content possibilities, while also having a relatively low hole mobility (FIG. 2(b)). Depending on the laser design, p-type cladding and waveguiding layers are responsible for -50% of the laser series resistivity, which means that -50% of the laser's heat is generated in these layers. Because of poor thermal resistivity (see FIG. 2(a)), this heat is not so efficiently extracted, resulting in increasing junction temperature (self-heating) during operation and hence deterioration of the laser performance at high operating currents.

Referring to the shaded regions in the graphs of FIG. 2, it is clear that it would be beneficial to use AlGaAs layers with >90% Al content (and even more beneficial to use pure p-type AlAs layers). As mentioned above, a significant problem in this case is that such layers are easily oxidized when exposed to air. This happens for example, when the ridge waveguide is defined in single mode laser. Formed oxide layers can be detrimental for the laser performance and reliability.

These various difficulties in balancing the competing factors of desired high aluminum content versus minimizing oxidation are addressed by the present invention by using an inverted junction structure so that the lower aluminum content n-type material is positioned above the active region and processed to form the desired ridge structure with minimal oxidation problems.

In order to maintain the use of the preferred n-type GaAs substrate (referred to hereafter as the n-GaAs substrate), a tunnel junction is formed on top of the substrate prior to introducing the p-type cladding and waveguiding layers. The tunnel junction is used to convert the flow of electrons from the substrate into a flow of holes suitable as required for carrier movement through p-type material. While the tunnel junction does introduce a degree of resistivity into the electrical path, its influence can be minimized, as will be discussed below. By virtue of moving the p-type portion of the laser diode below the active region, the p-type cladding layer may be formed of AlAs, which has a lower thermal resistivity than AlGaAs and thus further improves the heat dissipation at higher power levels. In addition, the thickness of the p-type cladding layer can be reduced by ~2 times (when compared to the p-type cladding layer thickness in typical AlGaAs-based lasers), which will allow to compensate for the finite resistivity introduced by the presence of the tunnel junction.

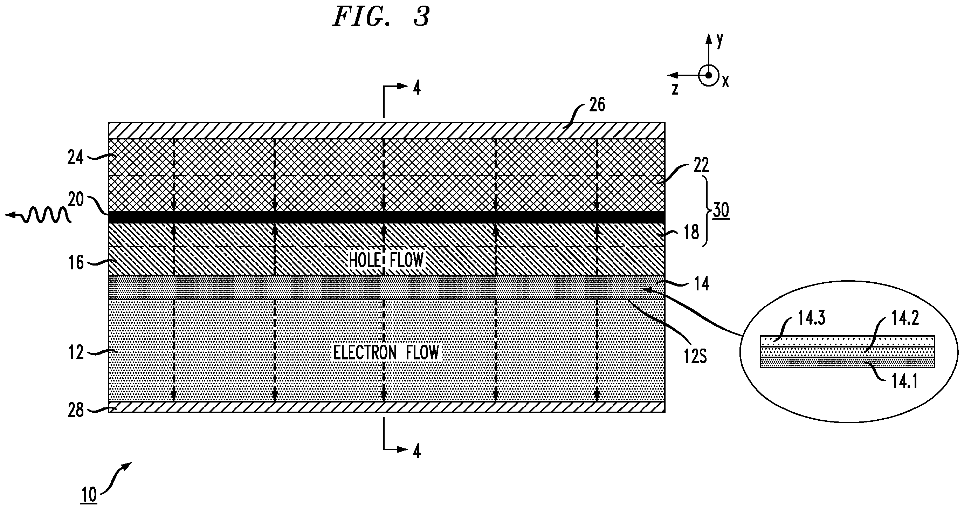

FIG. 3 illustrates an inverted junction GaAs-based semiconductor laser 10 formed in accordance with the principles of the present invention. Similar to the prior art, the inventive laser structure is based upon the use of an n-type GaAs (n-GaAs) substrate 12, which is preferably a single crystal structure. In order to convert the flow of electrons through n-GaAs substrate 12 into a flow of holes as necessary for an inverted junction configuration, a tunnel junction 14 is grown (or otherwise formed) on the exposed top surface 12S of n-GaAs substrate 12. While the presence of tunnel junction 14 introduces a degree of resistivity to the flow toward the active region, it can be minimized by careful design of tunnel junction layer 14, as will be described in detail below.

Continuing with the description of inverted junction laser diode 10, a p-type cladding (p-cladding) layer 16 and a p-type waveguiding (p-waveguiding) layer 18 are then grown in sequence over tunnel junction 14. An active region 20 is then fabricated over p-waveguiding layer 18. Active region 20 may comprise any suitable configuration well-known in the art, including but not limited to, a double heterostructure (DH), quantum well (QW), multiple QW (MQW), quantum dots/ dashes/wires.

In accordance with the inverted junction formation, an n-type waveguiding (n-waveguiding) layer 22 and an n-type cladding (n-cladding) layer 24 are subsequently formed over active region 20. A first n-type ohmic n-contact 26 is shown as formed over n-cladding layer 24, with a second n-type ohmic p-contact 28 formed across the back side of n-GaAs substrate 12. As a result of using a pair of like-conductivity electrical contacts, the application of an electrical drive current input to inverted junction GaAs-based laser diode 10 results in the creation of an electron flow from ohmic n-contact 26 to ohmic p-contact 28 (as illustrated in FIG. 3). The presence of tunnel junction 14 converts the electron flow towards second ohmic p-contact 28 into a flow of holes toward active region 20.

In one exemplary embodiment, tunnel junction 14 may comprise a multi-layer arrangement of a highly-doped n-type layer 14.1, an intrinsic layer 14.2, and a highly-doped p-type layer 14.3 (illustrated as an inset in FIG. 3). Doping levels on the order of, for example 5E19 cm⁻³ may be used, where this high doping concentration enables the Fermi level under equilibrium to be above the conduction band for n-type material, and also below the valence band for p-type material without the need to provide any additional external bias. Thus, when laser diode 10 itself is under forward bias, tunnel junction 14 itself is under reverse bias, enabling the required flow of both holes and electrons into active region 20. The combination of p-waveguiding layer 18, active region 20 and n-waveguiding layer 22 may be referred to at times as the "inverted junction 30" of GaAs-based semiconductor laser diode 10.

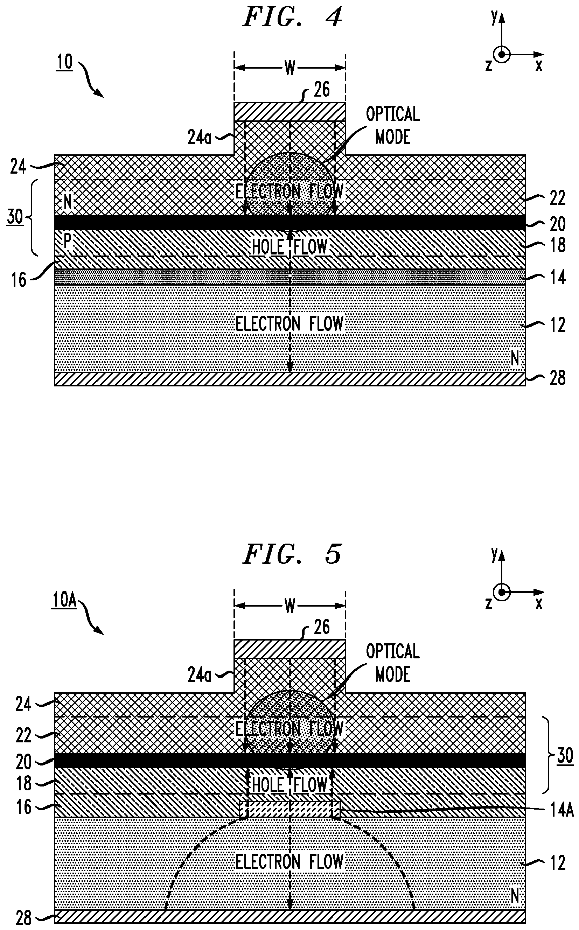

High-efficiency, high-power edge-emitting GaAs-based semiconductor lasers are typically formed to include a ridge structure to provide both optical and electrical (current) confinement in the area above the active region. FIG. 4 illustrates this ridge structure, where FIG. 4 is a view of inverted junction laser 10, taken along line 4-4 of FIG. 3. The confinement ridge is denoted as ridge 24a in FIG. 4. In this view, where the optical output along the z-axis is perpendicular to the drawing, the positioning of the optical mode is also shown.

The n-type AlGaAs layers typically used in the cladding and waveguiding regions of an edge-emitting semiconductor laser have an Al content below 40% (in contrast to the >90% for the p-type material). Therefore, the use of n-type material in creating ridge 24a does not result in oxidation, which has been problematic in the prior art use of p-type cladding material in this location in the device stack. Furthermore, electrons also have about ten times greater carrier mobility as compared to holes, and as a result the n-type AlGaAs layers exhibit a much lower resistivity, that results in less heat generation during laser operation. The optical mode intensity will exhibit a smaller gradient within n-cladding layer 24 than found in typical p-type layers and as a result will be less sensitive to etch depth variation for mode control in creating ridge 24a.

Moreover, the re-positioning of the p-type layers allows for p-cladding layer 16 to be formed of AlAs, which has a higher thermal conductivity than the conventional AlGaAs (about 1 cmK/W for AlAs, as compared to about 8 cmK/W for AlGaAs with about 40% Al content (see FIG. 2(a)) and thus further reduces the thermal resistivity of the p-side of the structure. The presence of a more efficient heat removal system when using AlAs as the p-cladding layer also minimizes unwanted heat-related non-linear effects, such as self-heating, self-focusing, spatial hole burning, and the like.

It is clearly shown in the view of FIG. 4 that tunnel junction 14 does not overlap the optical mode. Therefore, it is possible to use materials within a relatively low band gap (for example, GaAs and/or InGaAs) in the formation of tunnel junction 14. The low band gap materials enhance the tunnelling properties of the structure and thus reduce the added resistivity associated with the presence of the tunnel junction in the first instance.

For further improving the performance of edge-emitting semiconductor laser diodes, it is becoming necessary to reduce the effect of current spreading. While the ridge structure functions to minimize current spreading between the "top" ohmic contact and the active region, there is no similar physical constraint in the structure between the "bottom" ohmic contact and the active region. This problem may also be addressed in accordance with the principles of the present invention, by controlling the configuration of the tunnel junction in a manner that restrains electron/hole flow.

FIG. 5 is a cut-away end view of an exemplary inverted junction edge-emitting laser diode 10A, where the topology of the included tunnel junction is configured to provide current confinement within the lower region of the laser diode.

Laser diode 10A comprises the same layers as the structure discussed above in association with the discussion of FIGs. 3 and 4. However, in this case, the regular layer structure of tunnel junction 14 is replaced by a strip configuration 14A (extending into the page). In order to best confine hole flow into active region 20, tunnel junction strip 14A is positioned directly beneath the optical mode and formed of a width W that is substantially the same as ridge 24A. Our co-pending application [LE030] contains an extended discussion on the use of "current restrictors" along the path between the bottom ohmic contact and laser diode active region, and is herein incorporated by reference.

In most cases, a conventional type of patterning and etching process may be used to transform a grown/ deposited tunnel junction 14 into a tunnel junction strip 14A. By removing the extraneous portions of the material of tunnel junction 14, n-p-n current blocking regions are formed and thus encourage the current confinement in the manner shown in FIG. 5.

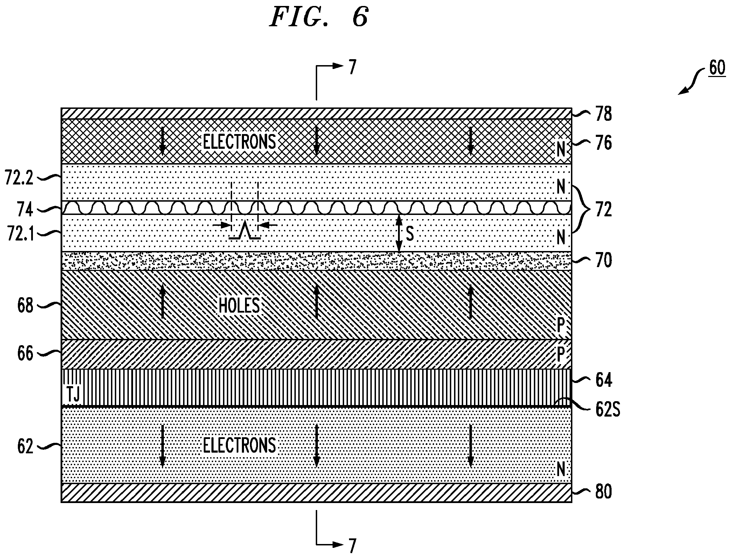

FIG. 6 illustrates another embodiment of an inverted junction GaAs-based semiconductor laser formed in accordance with the principles of the present invention. In this case, an inverted junction laser 60 takes the form of a distributed feedback (DFB) laser. As is well-known in the art, a DFB laser includes a Bragg grating that is positioned along the longitudinal axis of the structure in relatively close proximity to the active region. The presence of the grating creates a resonance in the center of the laser's reflectivity band such that the output emission is narrowed to essentially "lock" on the resonance value and provide a stable, single-wavelength device.

Referring to the particular elements illustrated in FIG. 6, inverted junction DFB laser 60 is shown as based on an n-GaAs substrate 62, which is preferably a single crystal structure. In order to convert the flow of electrons through n-GaAs substrate 62 into a flow of holes as necessary for an inverted junction configuration, a tunnel junction 64 is grown (or otherwise formed) on the exposed top surface 62S of n-GaAs substrate 62. A p-cladding layer 66 and a p-waveguiding layer 68 are then grown in sequence over tunnel junction 64. An active region 70 is then fabricated over p-waveguiding layer 68. Similar to inverted junction laser 10 discussed above, active region 70 may comprise any suitable configuration well-known in the art.

Inverted junction DFB laser 60 further includes an n-waveguiding layer 72 formed over active region 70. In order to create the resonant structure required for a DFB laser, a Bragg grating structure 74 is formed within n-waveguiding layer 72, using methods well-known in the art. Bragg grating structure 74 is formed to exhibit a period A that creates a resonance at the laser's output wavelength. An n-cladding laser 76 is shown as formed over n-waveguiding layer 72/ grating 74. A first n-type ohmic n-contact 78 is shown as formed over n-cladding layer 76, with a second n-type ohmic p-contact 80 formed across the back side of n-GaAs substrate 62. As with inverted junction laser 10 discussed above, the presence of tunnel junction 64 converts the electron flow towards second ohmic p-contact 80 into a flow of holes toward active region 70.

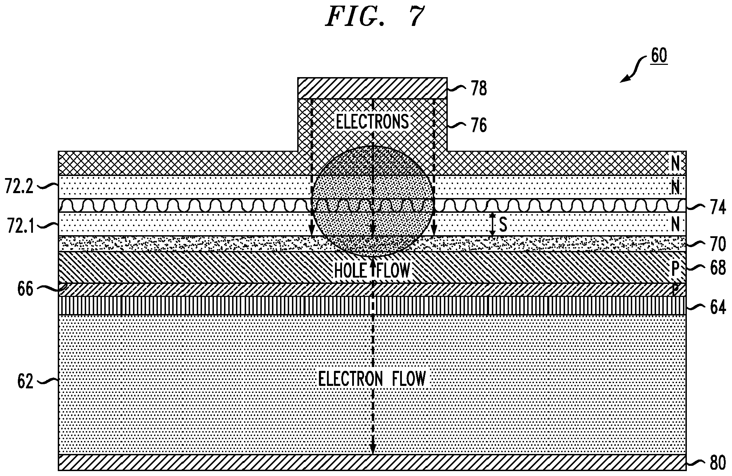

I n accordance with the principles of the present invention, the use of an inverted junction configuration in a GaAs-based DFB laser allows for the grating to be formed within n-type material, rather than p-type as found in prior art DFB lasers. Recall that by virtue of inverting the locations of the n-type and p-type waveguiding layers, the optical mode intensity will exhibit a smaller gradient that conventional DFB structures. Thus, grating structure 74 may be positioned further away from active region 70 than prior art configurations based on forming the grating structure within a p-type material. FIG. 7 is a view of inverted junction DFB laser 60, taken along line 7-7 of FIG. 6. The position of the optical mode is also shown in this view, which clearly illustrates the overlap of the optical mode between active region 70 and grating structure 74, as well as the spacing S between active region 70 and grating structure 74.

The ability to increase the spacing between active region 70 and grating structure 74 without impacting device performance allows reduces the impact of various impurities and defect formations that may be introduced during the process of forming grating structure 74. Moving the overgrowth interface between n-waveguiding layer 72 and grating structure 74 further away from active region 70 also limits the impact of any impurities that may be present at this interface. Moreover, inasmuch as the optical mode intensity exhibits a relatively small gradient, the coupling strength between active region 70 and grating structure 74 may be better controlled.

The embodiments and examples set forth herein are presented to best explain the present invention and its practical applications and to thereby enable those skilled in the art to make and utilize the invention. Those skilled in the art, however, will recognize that the foregoing description and examples have been presented for the purpose of illustration and example only. Other variations and modifications of the present invention will be apparent to those of skill in the art, and it is the intent of the appended claims that such variations and modifications be covered. Indeed, it is contemplated that the use of an inverted junction structure in an edge-emitting GaAs-based laser may be preferred in a variety of situations where a high-power laser diode is required, such as in a 980nm pump laser, broad area single-emitting lasers, bar lasers, etc.

The description as set forth is not intended to be exhaustive nor to limit the scope the of the invention. Many modifications and variations are possible in light of the above teaching without departing from the spirit and scope of the following claims. It is contemplated that the use of the present invention can involve components having different characteristics. It is intended that the scope of the present invention be defined by the claims appended hereto, giving full cognizance to equivalents in all respects.

## Claims

1. An edge-emitting GaAs-based laser, comprising:
an n-type GaAs substrate having a top major surface and an opposing bottom major surface;
a tunnel junction formed on the top major of the n-GaAs substrate;
a p-type cladding layer formed over the tunnel junction;
a p-type waveguiding layer formed over the p-type cladding layer;
an active region disposed on the formed p-type waveguiding layer;
an n-type waveguiding layer formed over the active region;
an n-type cladding layer formed over the n-type waveguiding layer;
a first n-type ohmic contact coupled to the n-type cladding layer; and
a second n-type ohmic contact coupled to the bottom major surface of the n-type GaAs substrate.

2. An edge-emitting GaAs-based laser as defined in claim 1 wherein the p-type cladding layer is formed of a semiconductor composition including aluminum, with an aluminum content exceeding 40% of the semiconductor composition.

3. An edge-emitting GaAs-based laser as defined in claim 2 wherein the aluminum content of the p-type cladding layer exceeds 90%.

4. An edge-emitting GaAs-based laser as defined in claim 1 wherein the p-type cladding layer comprises AlGaAs.

5. An edge-emitting GaAs-based laser as defined in claim 1 wherein the p-type cladding layer comprises AlAs.

6. An edge-emitting GaAs-based laser as defined in claim 1 wherein the n-type cladding layer is formed in include a ridge structure for confinement of an optical mode field.

7. An edge-emitting GaAs-based laser as defined in claim 6 wherein the tunnel junction is configured as a strip aligned with the ridge structure of the n-type cladding layer.

8. An edge-emitting GaAs-based laser as defined in claim 1 wherein the edge-emitting GaAs-based laser is formed as a distributed feedback laser and further comprises
a Bragg grating formed within the n-type waveguiding layer and disposed parallel with the active region.

9. An edge-emitting GaAs-based laser as defined in claim 8 wherein the Bragg grating is positioned at a spaced-apart location from the active region sufficient to minimize interaction between an overgrowth interface of the Bragg grating and the active region.

10. A method of forming an edge-emitting GaAs-based laser, including the steps of:
providing an n-type GaAs substrate having a top major surface and an opposing bottom major surface;
forming a tunnel junction on the top major of the n-GaAs substrate;
forming a p-type cladding layer over the tunnel junction;
forming a p-type waveguiding layer over the p-type cladding layer;
disposing an active region on the formed p-type waveguiding layer;
forming an n-type waveguiding layer over the active region;
forming an n-type cladding layer over the n-type waveguiding layer;
depositing a first n-type ohmic n-contact on the n-type cladding layer; and
depositing a second n-type ohmic p-contact on the bottom major surface of the n-type GaAs substrate.

11. The method as defined in claim 10 where an epitaxial growth process is used to form the p-type and n-type layers.

12. The method as defined in claim 10 wherein the step of forming the tunnel junction includes the steps of:
depositing a layered structure of highly-doped n-type and p-type materials;
patterning the layered structure to define a strip in alignment with an optical mode region; and
etching the patterned, layered structure to remove the highly-doped p-type and n-type material from regions outside of the strip location.

13. The method as defined in claim 10 wherein the step of forming the n-type waveguiding layer includes the step of creating a Bragg grating structure with a Bragg wavelength corresponding to the output wavelength of the edge-emitting GaAs-based laser, forming a distributed feedback laser.
